Europäisches Patentamt

European Patent Office

Office européen des brevets

(11) Publication number: **0 448 713 B1**

## EUROPEAN PATENT SPECIFICATION

(45) Date of publication of patent specification: **27.10.93**  (51) Int. Cl.⁵: **H01L 23/52**

(21) Application number: **89908519.5**

(22) Date of filing: **21.07.89**

(86) International application number:
**PCT/JP89/00730**

(87) International publication number:
**WO 90/01215 (08.02.90 90/04)**

(54) **SEMICONDUCTOR DEVICE.**

(30) Priority: **22.07.88 JP 184191/88**

(43) Date of publication of application:
**02.10.91 Bulletin 91/40**

(45) Publication of the grant of the patent:
**27.10.93 Bulletin 93/43**

(84) Designated Contracting States:
**DE**

(56) References cited:
**EP-A- 0 154 431**
**JP-A- 5 853 847**
**JP-B- 5 756 216**

**IEEE TRANSACTIONS ON COMPONENTS, HY-BRIDS AND MANUFACTURING TECHNOL-OGY, vol. 10, no. 1, March 1987, pages 111-121, New York, NY, US; S.K. TEWKES-BURY et al.: "Chip alignment templates for multichip module assembly"**

(73) Proprietor: **NIPPONDENSO CO., LTD.**
**1-1, Showa-cho**
**Kariya-city Aichi-pref., 448(JP)**

Proprietor: **NIPPON SOKEN, INC.**
**14 Iwaya Shimohasumi-cho**
**Nishio-City Aichi-Pref. 445(JP)**

(72) Inventor: **OHARA, Fumio**
**41, Ooaza Fukouzuaza Egego Kouta-cho**
**Nukata-gun**
**Aichi-Pref. 444-01(JP)**
Inventor: **KAWAI, Toshiyuki**
**83, Ishizuka Hanada-cho**
**Toyohashi-city**
**Aichi-Pref. 440(JP)**
Inventor: **SAKAKIBARA, Nobuyoshi**
**8-1, Awara Yamashita-cho**
**Nishio-city**
**Aichi-Pref. 445(JP)**

Rank Xerox (UK) Business Services
(3.10/3.6/3.3.1)

EP 0 448 713 B1

**I.E.E.E. JOURNAL OF SOLID STATE CIRCUITS,**
**vol. SC-21, no. 5, October 1986, pages**
**845-851, New York, US; R.W. JOHNSON et al.:**
**"Silicon hybrid wafer-scale package technol-**
**ogy"**

Inventor: **HUZINO, Seizi**
**84-50, Ooyama Anjo-cho**
**Anjo-city Aichi-Pref. 446(JP)**
Inventor: **HATTORI, Tadashi**
**2-66, Kuyoubou Shinden-cho**
**Okazaki-city**
**Aichi-Pref. 444-31(JP)**
Inventor: **KAWAMOTO, Kazunori**
**1-24, Shiroahara Sakurai-cho**
**Anjo-city**
**Aichi-Pref. 444-11(JP)**

(74) Representative: **KUHNEN, WACKER & PART-**
**NER**
**Alois-Steinecker-Strasse 22**
**D-85354 Freising (DE)**

## Description

The present invention relates to a semiconductor device which is, for instance, highly integrated and has an improved reliability.

From EP-A-0 154 431 an integrated circuit chip assembly is disclosed wherein at least one integrated circuit chip is attached to a substrate of a single crystal material, said at least one chip being electrically connected to lithographically connected circuitry on the substrate. The chips may be on top or on the bottom of the substrate or both, may be placed within wells or grooves in the substrate or may be placed above or below the wells or grooves via peripheral attachment of the chips. Walls of the wells or grooves permit alignment by match-up with beveled edges of some chips.

From IEEE Journal of Solid State Circuits, Vol. SC-21, No. 5, October 1986, p. 845 - 851, New York, USA; it is disclosed to mount IC chips in holes etched through silicon wafers. Chips are interconnected via the wafer using standard multilevel metallization processes.

From IEEE Transactions on Components, Hybrids and Manufacturing Technology, Vol. CHMT-10, No. 1, March 1987, p. 111 - 121, New York, USA; it is disclosed to provide a chip template aligned to and permanently mounted on a hybrid substrate. The templates are double-sided etched with a minimum opening at the centre of cavity.

According to the conventional microminiaturization of the wiring pattern in hybrid integrated circuits, such microminiaturization has the following advantages:

1. High-density integration of circuits
2. High-speed operation of circuits by shortening the length of circuits
3. Improvement in reliability by reducing the number of contact elements

It is known that there is a flip-chip type hybrid integrated circuit in which a solder bump is formed on a wiring pad of a semiconductor chip or on a substrate on which the wiring is formed, so that the semiconductor chip is coupled to and therefore contacted with the substrate by the vamp. However, according to this flip-chip type, since the adhesive area became the bump area and required a large area so that the wiring pitch was between 150 and 200 microns for improving the adhesive strength, the microminiaturisation of the wiring pitch was difficult. On the other hand, a buried type hybrid integrated circuit is proposed. According to the buried type, after a semiconductor chip is buried by epoxy resin in a hole formed on a substrate, contact wiring is formed. However, since the position of the buried semiconductor chip is not accurate, the microminiaturization of the wiring pitch is difficult in the process of forming the contact wiring.

Therefore, an object of the present invention is to improve the accuracy of the position of the semiconductor chip easily and to reduce the wiring pitch to a large extent.

The object is solved by a semiconductor device having the feature of claim 1. A semiconductor device of the present invention is characterized by the following elements; namely: a semiconductor device comprises a substrate on which is a coupling hole having a tapered portion;

The coupling-hole is a through-hole which goes through the substrate. The coupling-hole has first and second taper portions. The first taper portion is formed on the main surface of the substrate so that the opening area of the main surface of the substrate is larger than the area of the inside portion of the substrate. On the other hand, the second taper portion is formed on the opposite side of the main surface of the substrate so that the opening area of the opposite side is larger than the area of the inside portion of the substrate. According to this structure, even if a gap between the main surface of the substrate and the surface of the semiconductor chip occurs, adverse influence of such gap can be reduced by the first taper portion, and therefore disconnection of the wiring can be prevented.

a semiconductor chip, on which an element is formed, having a tapered portion corresponding to the coupling hole;

a coupling member for coupling the substrate to the semiconductor chip so that the taper portion of the coupling hole corresponds to the tapered portion of the semiconductor chip;

a leveling layer formed across the substrate and the semiconductor chip; and

wiring electrically connected to the element, at least a part thereof being formed on the leveling layer.

By using the above structure, the accuracy of the chip in a horizontal direction can be easily improved because the tapered portion of the semiconductor chip is coupled to the tapered portion of the coupling hole and rub each other in the process for burying the semiconductor chip into the coupling hole. Such an improvement results in the reduction of the cost for controlling the position accuracy to the large extent and also reduce the wiring pitch extremely.

Both substrate and semiconductor chip are comprised of silicon having a face orientation of (100). Since the tapered portions of the coupling hole and the semiconductor chip can be formed by an anisotropic etching of the silicon, the angle of each tapered portion can be easily and accurately formed so that the tapered portion of the semiconductor chip is parallel to that of the coupling hole in the process for burying the semiconductor chip into the coupling hole. As the result, the semiconductor chip is hardly shifted to a wrong position. In other words, accuracy of its position and productivity can be improved.

Fig. 1 is a sectional view of a hybrid integrated circuit device according to a first example, not covered by the claims;

Fig. 2 (a) to (j) are sectional views showing a production process of the first example, not covered by the claims;

Fig. 3 is a sectional view of a second example, not covered by the claims;

Fig. 4 is a sectional view of a third example, not covered by the claims;

Fig. 5 is a sectional view of an embodiment of the present invention;

Fig. 6 is a schematic view indicating the characteristic structure of the embodiment of the present invention;

Fig. 7 (a) and (b) are sectional views showing a production process of the substrate;

Fig. 8 is a schematic view showing an effect of the embodiment of the present invention; and

Fig. 9 is a sectional view of an example of the embodiment of the present invention.

The present invention is explained in detail below by using the examples and embodiments shown in the drawings.

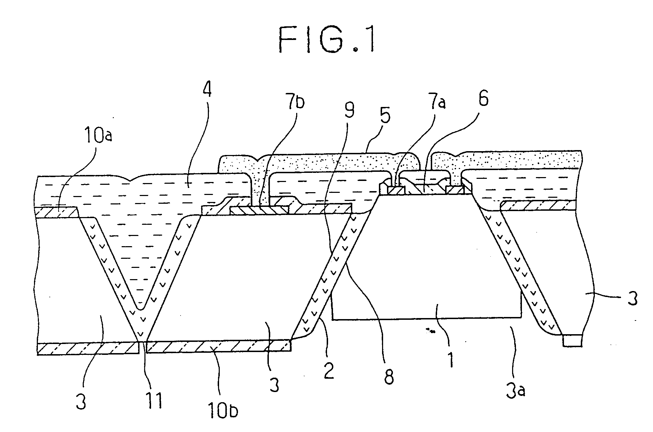

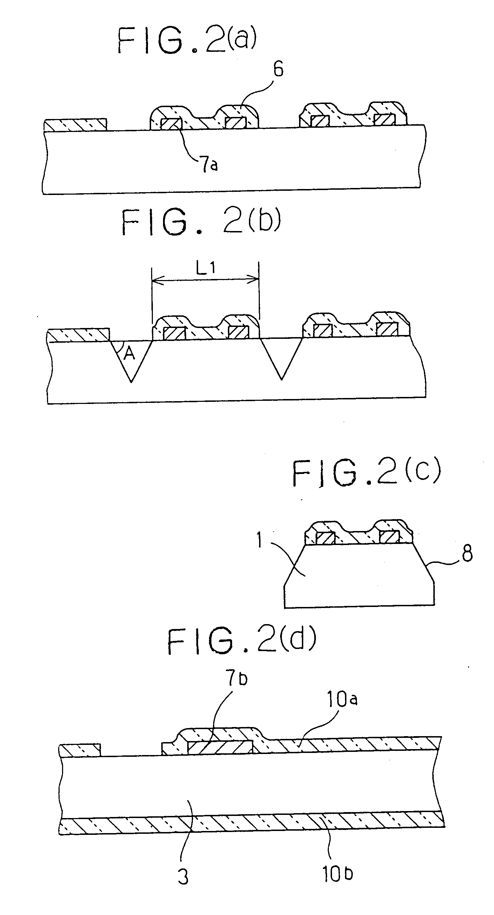

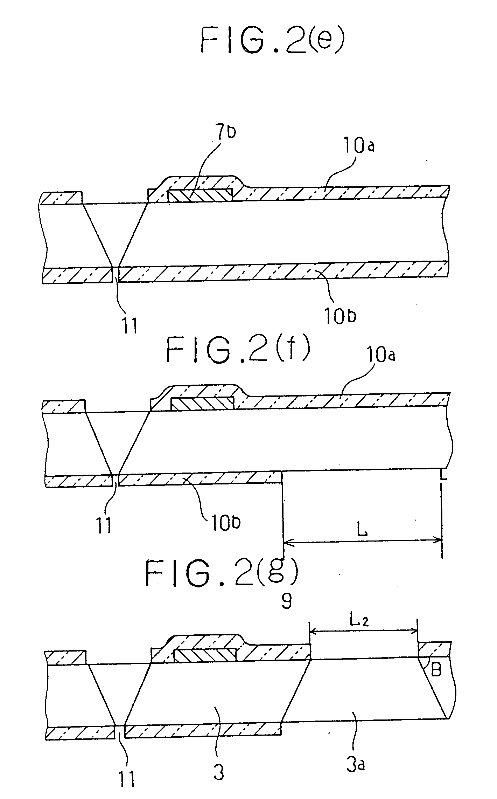

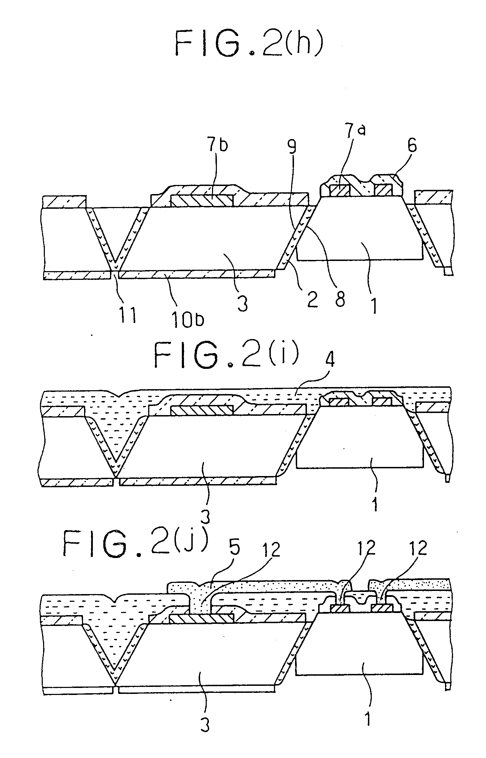

Fig. 1 shows a sectional view of a hybrid integrated circuit device according to Fig. 1 being not covered by the claims Figs. 2(a) to (j) show sectional views illustrating its production process. In Fig. 1, reference numeral 1 shows a semiconductor chip which is comprised of a silicon substrate having a face-orientation (100). A taper portion 8 is formed on the upper-end face by anisotropic etching. Reference numeral 2 shows an adhesive member (e.g. low-boiling point glass, resin such as polyimide and epoxy, and, eutectic). Reference numeral 3 shows a silicon substrate having a face-orientation of (100). A chip-coupling hole 3a is formed on the opposite side of the substrate by anisotropic etching so that its size is the same as that of the semiconductor chip 1.

If there is unevenness of $\pm \Delta t$ on the thickness of the substrate ($\pm \Delta t$ is approximately 15$\mu$m), the surface of the semiconductor chip 1 does not correspond to that of the substrate 3. Since it is difficult to connect the semiconductor chip 1 to the substrate 3 by film wiring in such a case, or if the surface of the semiconductor chip 1 does not protrude upwardly from the surface of the substrate 3, it is necessary to take a measure so that the surface of the semiconductor chip 1 is no lower than that of the substrate 3.

In this example, the device is supposed to be designed so that the surface of the semiconductor chip 1 corresponds to that of the substrate 3 when the thickness of the substrate 3 is the maximum (when the disperison is $+\Delta t$). So the maximum gap which might occur between the semiconductor chip 1 and the substrate 3 would be 2$\Delta t$. Accordingly, for the purpose of making the semiconductor chip 1 stick up from the surface of the substrate 3, it is necessary to design it beforehand so as to make the surface of the semiconductor chip 1 stick up by 2$\Delta t$. The leveling layer 4 is formed across the semiconductor chip 1 and the substrate 3 so as to level the gap which has been occurred. Polyimide resin or SOG(spin on glass) is applied to the material of the leveling layer 4.

Reference numeral 5 is wiring made of aluminum electrically connected to the semiconductor chip 1. Reference numeral 6 shows a passivation film of the semiconductor chip 1. Reference numeral 7a shows an electrode which is made of aluminum for instance and formed on the surface of the semiconductor chip 1' Reference numeral 7b shows an electrode which is formed on the surface of the substrate 3. Reference numeral 8 and 9 show taper portions which are formed by anistropic etching. Reference numeral 10a and 10b show a passivation film of the substrate 3. Reference numeral 11 shows a position-indication-hole for indicating the relationship between the main surface of the substrate 3 and the opposite side of the substrate 3. The semiconductor chip 1 and the substrate 3 include other elements such as transistors and resistances which are not illustrated in the drawings and electrically connected to the electrodes 7a and 7b, and wiring 5.

The production process of the hybrid integrated circuit shown in Fig. 1 is explained in detail below with reference to Figs. 2(a)-(j).

First of all, electrode 7a is formed on the semiconductor chip 1 after the elements such as transistors and resistances have been formed on the semiconductor chip 1 by conventional process such as impurity doping. Then, the passivation film 6 of nitride silicon is formed on the semiconductor chip 1 as shown in Fig. 2(a). Then, as shown in Fig. 2(b), a V shape ditch is formed by anisotropic etching which uses the partially opened passivation film 6 as a mask. The angle "A" of the V shape ditch is approximately 54.7°. Since the surface of the V shape ditch becomes a contacting surface, it is necessary to form it deeply in order to improve the coupling strength. The semiconductor chip 1 is cut along the V shape ditch as shown in Fig. 2(c) to obtain a unit chip.

On the other hand, both sides of the substrate 3 are covered with passivation films 10a and 10b as shown in Fig. 2(d) after the electrode 7b has been formed on the substrate 3. Then, the position-indication hole 11 is formed as shown in Fig. 2(e) by anisotropic etching which uses the partially opened passivation film 10a as a mask. The difference between the position of the electrode 7b and the back side of the substrate 3 is clarified by the presence of the position-indication-hole 11.

In the next step, the passivation film 10b is etched with reference to the position of the position-indication hole 11 as shown in Fig. 2(f). Then, the chip-coupling hole 3a is formed by anisotropic etching which uses the partially opened passivation film 10b as a mask as shown in Fig. 2-(g). The angle "B" between the taper portion and the main surface of the substrate 3 is set at about 54.7°. In this process, the length "L" is determined so that the surface length "L2" of the chip-coupling hole 3a.

The above processed semiconductor chip 1 is coupled to the above processed substrate 3 through the adhesive member 2 as shown in Fig. 2(h). In this step, the adhesive member 2 has to be treated with heat which has no adverse influence on the elements (e.g. below 500°C in case aluminum wiring is used in the elements). In addition to this requirement, the adhesive member 2 has to withstand that heat-treatment in the next process for forming the leveling layer 4 shown in Fig. 2(i).

In the step for forming the leveling layer 4, a polyimido resin is used as the leveling layer 4 and treated with the maximum temperature 350°C.

For the reason, a low-boiling point glass or polyimido resin is used in the adhesive member 2.

After the above-leveling step, a contact hole 12 is formed by $O_2$ plasma etching for instance as shown in Fig. 2(j). Then, aluminum film is formed by vapor deposition or sputtering. This aluminum film is etched in a pattern that forms the wiring 5 which connects the electrode 7a on the semiconductor chip 1 to the electrode 7b on the substrate 3. Even if the above-described leveling is insufficient, disconnection of the wiring 5 can be prevented because the gap portion has a taper angle of 125° and the chip surface protrudes upwardly from the surface of the substrate 3.

In case that other elements are formed on the substrate 3 beforehand, a further high-density integration can be obtained. For example, in case that the present embodiment is applied to an LSI device which is used in a Fuzzy logic, its CPU may be formed on the substrate 3 and its memory such as EEPROM may be formed on the semiconductor chip 1. When such a memory and CPU are integrated into one chip, additional masks are required. However, if such elements are formed on the substrate 3 and the semiconductor chip 1, respectively, the number of the masks can be reduced.

According to the example, the semiconductor chip 1 and the substrate 3 have taper portions 8 and 9, respectively, and they are coupled to each other so that each taper portion corresponds to each other. So the accuracy of the chip position in the horizontal direction can be improved since the tapered portion 8 is couple to the tapered portion 9 through the adhesive member 2 with a rubbing movement. Both taper portions 8 and 9 are accurately formed by anisotropic etching. In the etching process of the silicon having the face orientation (100), since the etching mask has an square opening, its etching proceeds with exposing an equivalent face along the square opening. As a result, all taper angles of the tapered portions are the same angle (54.7°) and taper portion 8 becomes parallel to the taper portion 9.

Since the accuracy of the positions of the semiconductor chip 1 and the substrate 3 is improved, an incorrect shift between electrodes 7a, 7b and wiring 5 does not occur, and therefore the wiring pitch can be significantly reduced.

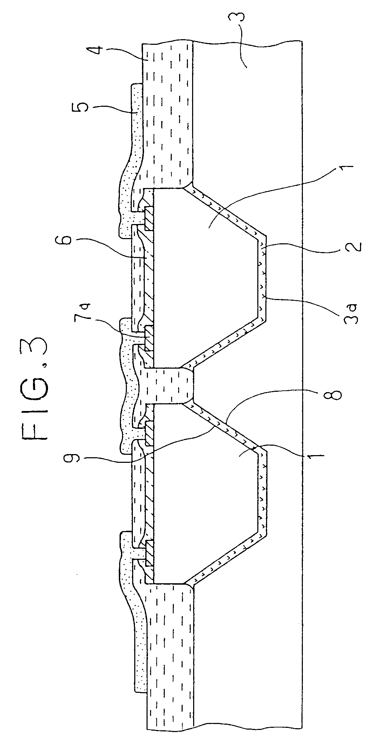

A second example not being covered by the claims is explained with reference to Fig. 3. In this example, the taper portion 9 of the semiconductor chip 1 is formed in its back side by anisotropic etching, and the taper portion 8 of the substrate 3 is formed in its main surface in the same etching technique. The taper portion 9 is coupled to the taper portion 8 by the self-aignment coupling. The chip-coupling hole 3a of the second example is not a through-hole. According to the second example, since the depth and the interval of the semiconductor chip 1 can be determined independently of the substrate 3, further high-density integration can be obtained. However, as the semiconductor chip 1 protrudes upwardly from the surface of the substrate 3 corresponding to its depth, such protruding portion has to be leveled by a polyimido resin layer 4.

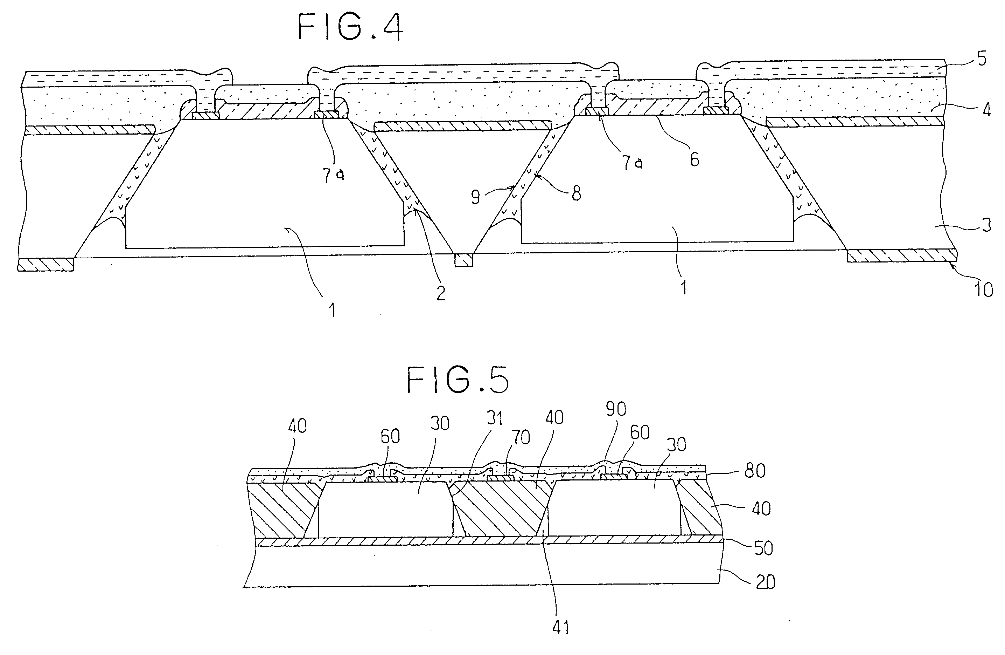

A third example not being covered by the claims is explained with reference to Fig. 4. Most of the structures of the third example are the same as those of the first example. However, according to the third example, a plurality of semiconductor chips 1 are connected to one another by wiring 5 while in the first example the semiconductor chips 1 is connected to the substrate 3 by wiring 5. With regard to the other structure in the second and the third examples, the reference numerals identical to those of the first examples denote the same elements as those of the first example. It is obvious that such elements have the same effect as those in the first example.

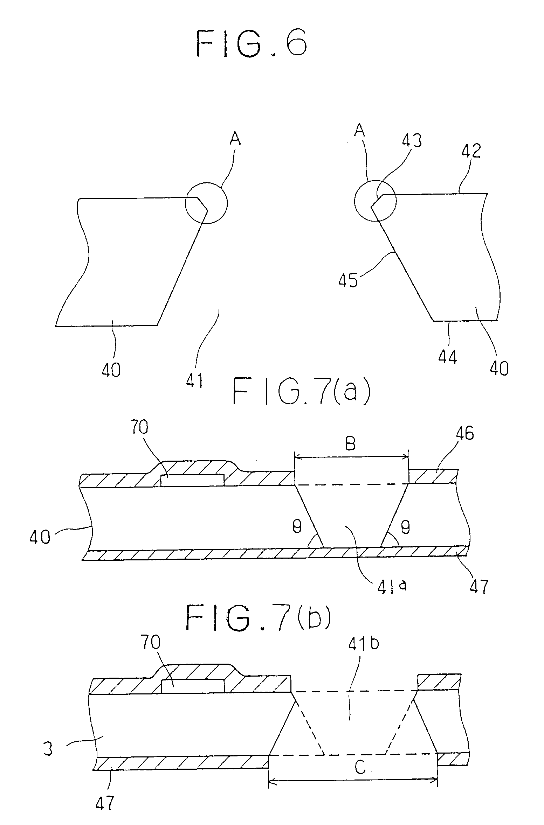

An embodiment of the present invention is explained with reference to Figs. 5 through 9. The embodiment is made for effectively reducing the maximum gap between the semiconductor chip 1 and the substrate 3, which occurs from the random thickness of the substrate 3. Accordingly, such reduction is preferable to the later process such as the leveling process and prevents the wiring from disconnection. Fig. 5 illustrates the basic structure of the present invention. Fig. 6 illustrates a characteristic portion of the present embodiment, namely the sectional view of a hole formed in a wiring-substrate 40. Figs. 7(a) and (b) show a process of the hole shown in Fig. 6.

In Fig. 5, a substrate 20 is a flat board such as silicon wafer, ceramic board, metal board or glass board. Reference numeral 30 designates a semiconductor chip made of silicon having the face-orientation (100). A taper portion 31 is formed on the upper part of the semiconductor chip 30 by anisotropic etching (alkali solvent). Reference numeral 40 denotes a silicon substrate which has the face-orientation (100). This silicon substrate 40 is used for forming wiring. Reference numeral 50 denotes an adhesive member for coupling the semiconductor chip and the substrate 40 with a flat substrate 20 (e.g., low-boiling-point glass or polyimide resin, etc.). Reference numeral 41 denotes a coupling-hole, which is formed by anisoropic etching. The coupling hole 41 has a first taper portion 43 formed on a main surface 42 as indicated by a circle A in Fig. 6 and a second taper portion 45 formed in the substrate 40. So the opening area of the inside of the coupling hole 41 is smaller than that on the main surface of the substrate 40, and the opening area of the inside of the coupling-hole 41 is smaller than that on the opposite side 44 of the substrate 40. In Fig. 5, reference numerals 60 and 70 designate electrodes, and 80 and 90 designate a leveling layer and wiring, respectively.

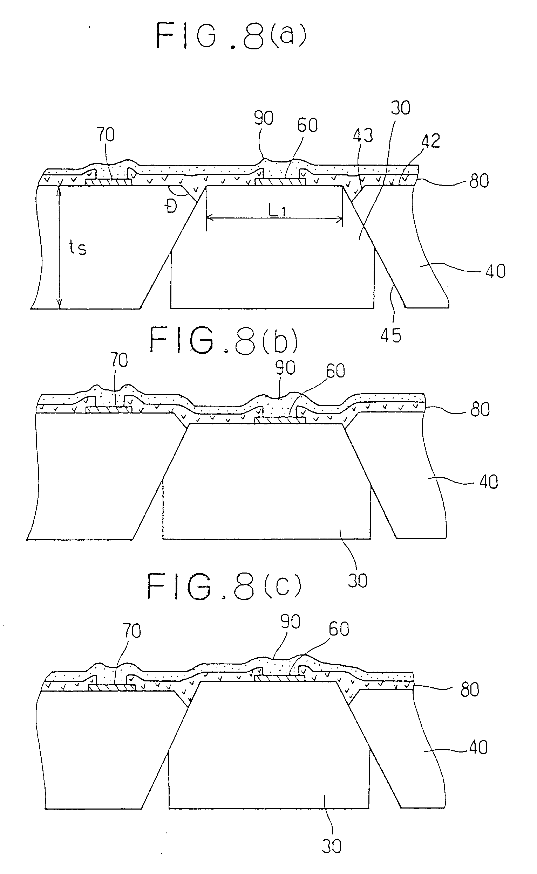

Fig. 7 illustrates the process for manufacturing the coupling hole 41. The length of "B" and "C" shown in Fig. 8(a) may be estimated by the following expression:

$$B = L_1 + 2 \Delta t / \tan\Theta \qquad (1)$$

$$C = L_1 + 2ts.\tan(90° - \Theta) \qquad (2)$$

In the above expression, $L_1$, ts, and $\pm\Delta t$ designate the length of the upper-plain portion of the semiconductor chip 30, a thickness of the substrate 40 and an unevenness, respectively. Designation $\Theta$ indicates an angle ($54.7°$ to silicon (100)) of a taper which is formed in an anisotropic etching.

In the process shown in Fig. 7(a), etching mask films 46 and 47 made of $SiO_2$ or $Si_3N_4$ are formed on opposite sides of the substrate 40 so as to form a tapered hole 41a in size B. Then, as shown in Fig. 7(b), the etching mask film 47 on the opposite side of the substrate 40 has etched a tapered hole 41b in the length C by anisotropic etching. In this process, both etching mask films 46 and 47 may be etched by anisotropic etching at the same time.

By using the above described structure in the tapered hole 41b, the laterprocesses shown in Figs. 8(a)-(c) can be obtained irrespective of the thickness of the semiconductor chip 30. Fig. 8(a), Fig. 8(b) and Fig. 8(c) show a case in which the thickness of the semiconductor chip 30 equals that of the substrate 40, and a case in which the semiconductor chip 30 is thinner than the substrate 50, respectively. The gap which occurs at a coupling portion when the taper portion of the semiconductor chip 30 is coupled to the taper hole of the substrate 40, may be absorbed by the adhesive member 50 using other material such asresin (i.e., an adhesive which is hardened by a heat treatment). According to the present embodiment, an angle "D" formed between the main surface 42 of the substrate 40 and the first taper portion 43 always becomes an obtuse angle regardless of the presence of the gap which occurs due to the unevenness between the thickness of the semiconductor chip 30 and that of the substrate 40, because the first tapered portion 43 is formed in the coupling hole 41 in addition to the second taper portion 45. As the result, even if substrate 40 is thicker than that of the semiconductor chip 30, a portion above the first tapered portion 43 becomes a gentle surface as shown in Fig. 8(b) so that disconnection of wiring 90 can be prevented effectively.

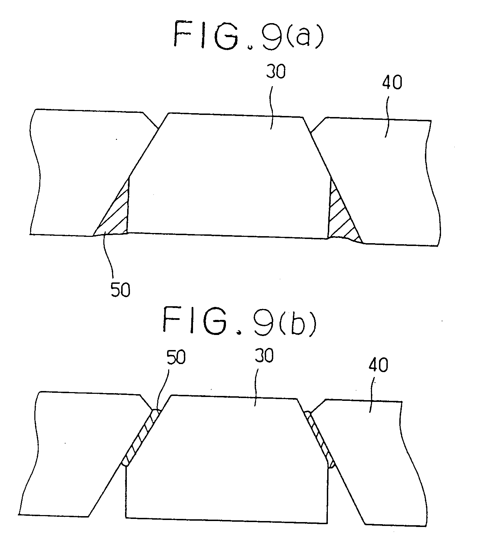

In this embodiment, there are other methods for coupling the semiconductor chip 30 to the substrate 40 without using the substrate 20. One of them is to fill the adhesive member 50 in a gap between the taper surface of the semiconductor chip 30 and that of the substrate 40 as shown in Fig. 9(a).

An other is to couple the semiconductor chip 30 to the substrate by the adhesive member 50 as shown in Fig. 9(b). These methods reduce the production cost because the substrate 20 is unnecessary according to these methods.

Although the present invention is described in accordance with the embodiment, it is not limited to the above described embodiment and the following modifications can be applied to the present invention.

(1) The substrate and the semiconductor chip are not limited to those using silicon having the face-orientation(100). Silicon having another face-orientation or other semiconductor material can be applied to them.

(2) It may be acceptable that the material of the semiconductor chip is different from that of the substrate. In case that a silicon having a face-orientation(100) is used as the substrate and that a gallium arsenide having a face-orientation $(1\bar{1}\bar{1})$, $(\bar{1}\bar{1}\bar{1})$ or $(\bar{1}11)$ is used as the semiconductor chip, the gallium arsenide should be etched by a etching fluid having the following components with a temperature of $21 + 2°C$:

$$H_2SO_4 : H_2O_2 : H_2O = 4{:}1{:}90$$

In this etching process, the taper angle of the gallium arsenide equals to the taper angle of the silicon (54.7°).

When the material of the semiconductor chip is different from that of the substrate, a complex integrated circuit such as a Hall-effect IC formed on the gallium arsenide can be obtained.

(3) According to the above embodiment, the tapered portion of the semiconductor chip is provided on only the upper part thereof. However, the tapered portion can be formed on all sides of the chip so as to form a truncated pyramid.

(4) The tapered portion can be formed by using a dicing-saw-blade which has a predetermined angle in order to obtain a required angle.

(5) The angle of the tapered portion is not limited to 54.7°.

(6) Semiconductor elements can be formed on the underside of the semiconductor chip as well as the upside thereof.

(7) The present invention can be applied to a so-called wafer integration technique which provides circuit elements on all surfaces Of the wafer. In that case, it would be unnecessary to provide lengthy wiring for a laser-cutting to a defect portion, because it would be possible to provide only a high quality chip which has no defect.

INDUSTRIAL APPLICABILITY

The present invention can be applied to a semiconductor device using a semiconductor chip which is directly coupled to a substrate, and is especially effective in being applied to a high-density integrated circuit or a semiconductor device in which a material of the semiconductor chip differs from that of the substrate.

**Claims**

1. A semiconductor device, comprising:
   a substrate (40) made of a semiconductor crystal material having a predetermined crystal face-orientation, in which a coupling hole (41) is formed such that said coupling hole (41) goes through the substrate (40) from a main side surface (42) of said substrate (40) to an opposite side surface (44) of said substrate (40), an opening size (C) of the coupling hole (41) at the opposite side surface (44) being larger than an opening size (B) of the coupling hole (41) at the main side surface (42); said coupling hole (41) having a first tapered portion (43) which is formed on the main surface (42) of said substrate (40) such that the area of said opening size (B) of said coupling hole (41) at the main surface of said substrate (40) is larger than an area of an inside portion of said substrate (40), and a second tapered portion (45) which is formed on the opposite side (44) of the main surface (42) of said substrate (40) so that the area of said opening size (C) of said coupling hole (41) at the opposite side surface (44) is larger than the area of said inside portion of said substrate (40);
   a semiconductor chip (30) made of a semiconductor crystal material and comprising a tapered portion (31) with a form such that said semiconductor chip (30) is arrangeable accurately into said coupling hole (41) of said substrate (40);
   a coupling member (50) for coupling said semiconductor chip (30) to said substrate (40) so that said second tapered portion (45) of said substrate (40) and said tapered portion (31) of said semiconductor chip (30) correspond to each other;
   a levelling layer (80) formed across said substrate (40) and said semiconductor chip (30);
   a wiring (90) electrically connected to an element formed on said semiconductor chip (30), at least a part of said wiring (90) being formed on said leveling layer (80).

2. The semiconductor device according to claim 1, wherein a main side surface of said semiconductor chip (30) protrudes upwardly from said main side surface (42) of said substrate (40).

3. The semiconductor device according to claim 1 or 2, wherein the substrate (40) and said semiconductor chip (30) are made of silicon.

4. The semiconductor device according to one of the previous claims, wherein said semiconductor chip (30) has the same crystal face-orientation as said substrate (40).

**Patentansprüche**

1. Halbleitervorrichtung, welche aufweist:
   ein aus einem Halbleiterkristallmaterial hergestelltes Substrat (40) mit einer vorbestimmten Kristallorientierung, in welchem eine Kopplungsöffnung (41) derart ausgebildet ist, daß die Kopplungsöffnung (41) durch das Substrat (40) ausgehend von einer Hauptseitenoberfläche (42) des Substrates (40) bis zu einer entgegengesetzten Seitenoberfläche (44) des Substrates (40) angeordnet ist, wobei eine Öffnungsgröße (C) der Kopplungsöffnung (41) bei der entgegengesetzten Seitenoberfläche (44) größer ist als eine Öffnungsgröße (B) der Kopplungsöffnung (41) bei der Kauptseitenoberfläche (42); wobei die Kopplungsöffnung (41) einen ersten, sich verjüngenden Abschnitt (43) aufweist, der auf der Hauptoberfläche (42) des Substrates (40) derart ausgebildet ist, daß die Fläche der Öffnungsgröße (B) der Kopplungsöffnung (41) bei der Hauptoberfläche des Substrates (40) größer ist als eine Fläche eines inneren Abschnittes des Substrates (40), und einen zweiten, sich verjüngenden Abschnitt (45) aufweist, der auf der entgegengesetzten Seite (44) der Hauptoberfläche (42) des Substrates (40) derart ausgebildet ist, daß die Fläche der Öffnungsgröße (C) der Kopplungsöffnung (41) der entgegengesetzten Seitenoberfläche (44) größer ist als die Fläche des inneren Abschnitt des Substrates (40); einen Halbleiterchip (30), der aus einem Halbleiterkristallmaterial hergestellt ist und einen sich verjüngenden Abschnitt (31) mit einer Form derart aufweist, daß der Halbleiterchip (30) paßgenau in der Kopplungsöffnung (41) des Substrates (40) anordenbar ist; ein Kopplungsteil (50) zum Koppeln des Kalbleiterchip (30) an das Substrat (40) derart, daß sich der zweite, sich verjüngende Abschnitt (45) des Substrates (40) und der sich verjüngende Abschnitt (31) des Halbleiterchips (30) gegenseitig entsprechen; eine Nivellierschicht (80), welche über das Substrat (40) und den Halbleiterchip (30) gebildet ist; eine Verdrahtung (90), die elektrisch mit einem auf dem Halbleiterchip (30) gebildeten Element verbunden ist, wobei zumindest ein Teil der Verdrahtung (90) auf der Nivellierschicht (80) gebildet ist.

2.  Halbleitervorrichtung nach Anspruch 1, bei dem die Hauptseitenoberfläche des Halbleiterchips (30) sich nach oben von der Hauptseitenoberfläche (42) des Substrates (40) erhebt.

3.  Halbleitervorrichtung nach Anspruch 1 oder 2, bei dem das Substrat (40) und der Halbleiterchip (30) aus Silizium hergestellt sind.

4.  Halbleitervorrichtung nach einem der vorhergehenden Ansprüche, bei dem der Halbleiterchip (30) dieselbe Kristallorientierung wie das Substrat (40) aufweist.

## Revendications

1.  Dispositif semi-conducteur, comportant :
    un substrat (40) fabriqué à partir d'un matériau cristallin semi-conducteur ayant une orientation de face cristalline prédéterminée, dans lequel un trou de raccordement (41) est formé de manière à ce que ledit trou de raccordement (41) traverse le substrat à partir d'une face latérale principale (42) dudit substrat (40) à une face latérale opposée (44) dudit substrat (40), une dimenseion d'ouverture (C) du trou de raccordement (41) à la face latérale opposée (44) étant plus grande qu'une dimension d'ouverture (B) du trou de raccordement (41) à la face latérale principale (42) ; ledit trou de raccordement (41) ayant une première partie conique (43) qui est formée sur la face principale (42) dudit substrat (40) de manière à ce que la zone de ladite dimension d'ouverture (B) dudit trou de raccordement (41) sur la principale face dudit substrat (40) soit plus grande qu'une zone d'une partie intérieure dudit substrat (40), et une seconde partie conique (45) qui est formée sur la face opposée (44) de la face principale (42) dudit substrat (40) de sorte que la zone de ladite dimension d'ouverture dudit trou de raccordement (41) sur la face latérale opposée (44) est plus grande que la zone de ladite partie intérieure dudit substrat (40) ;
    une puce semi-conductrice (30) fabriquée à partir d'un matériau cristallin semi-conducteur et comprenant une partie conique (31) qui a une forme telle que la puce semi-conductrice (30) puisse être placée avec précision dans ledit trou de raccordement (41) dudit substrat (40) ;
    un élément de raccordement (50) pour raccorder ladite puce semi-conductrice (30) audit substrat (40) de manière à ce que ladite seconde partie conique (45) dudit substrat (40) et ladite partie conique (31) de ladite puce semi-conductrice (30) correspondent réciproquement ;
    une couche de nivellement (80) formée à travers ledit substrat (40) et ladite puce semi-conductrice (30);
    un câblage (90) connecté de manière électrique audit élément formé sur ladite puce semi-conductrice (30), au moins une partie dudit câblage (90) étant formé sur ladite couche de nivellement (80).

2.  Le dispositif semi-conducteur selon la revendication 1, dans lequel une face latérale principale de ladite puce semi-conductrice (30) s'étend vers le haut à partir de ladite face latérale principale (42) dudit substrat (40).

3.  Le dispositif semi-conducteur selon les revendications 1 ou 2, dans lequel le substrat (40) et ladite puce semi-conductrice (30) sont fabriqués en silicium.

4.  Le dispositif semi-conducteur selon l'une quelconque des revendications précédentes, dans lequel ladite puce semi-conductrice (30) a la même orientation de face cristalline que ledit substrat (40).

# FIG.1

EP 0 448 713 B1

FIG.2(a)

FIG. 2(b)

FIG.2(c)

FIG.2(d)

11

# FIG.2(e)

# FIG.2(f)

# FIG.2(g)

# FIG.2(h)

# FIG.2(i)

# FIG.2(j)

FIG.3

FIG.4

FIG.5

# FIG.6

A

A   43   42

45

40   41   44   40

# FIG.7(a)

70   B   46

40   θ   θ

41a   47

# FIG.7(b)

70   41b

3

47   C

# FIG.8(a)

# FIG.8(b)

# FIG.8(c)

# FIG.9(a)

# FIG.9(b)